# EUROPÄISCHE PATENTSCHRIFT

(11) **EP 1 284 333 B1**
(45) Veröffentlichungstag und Bekanntmachung des Hinweises auf die Patenterteilung: **14.01.2009**
(21) Anmeldenummer: 02018411.5
(22) Anmeldetag: 16.08.2002
(51) Int. Cl.: E05B 17/22, H05K 7/02, H01H 13/06

(54) **Elektrische Bauelementanordnung**
Electric component assembly
Ensemble composant électrique

(30) Priorität: 17.08.2001 DE 10139356
(43) Veröffentlichungstag der Anmeldung: 19.02.2003
(73) Patentinhaber: Kiekert Aktiengesellschaft, 42579 Heiligenhaus (DE); Cherry GmbH, 91275 Auerbach (DE)
(72) Erfinder: Iffländer, Hans-Jürgen, 41334 Nettetal (DE); Mader, Martin, 45259 Essen (DE); Bauer, Günter, 92237 Sulzbach-Rosenberg (DE)
(74) Vertreter: Nunnenkamp, Jörg

(56) Entgegenhaltungen:
- DE-A1- 3 621 613
- DE-A1- 4 002 371
- DE-A1- 4 011 980
- DE-A1- 4 306 143
- FR-A- 2 134 815

## Beschreibung

Die Erfindung betrifft eine elektrische Bauelementanordnung, insbesondere zur Anbringung auf einem Schlossgehäuse mit eingelassenen Leiterbahnen eines Kraftfahrzeugtürverschlusses, mit einem Träger und einem Bauelement, wobei die Leiterbahnen in vom Träger vorkragende Leiterfahnen münden.

Bei dem elektrischen Bauelement handelt es sich regelmäßig um einen Schalter bzw. Mikroschalter, welcher bei einem Kraftfahrzeugtürverschluss üblicherweise dazu eingesetzt wird, Positionen einzelner mechanischer Bauteile abzufragen. Hierzu gehört insbesondere die obligatorische Drehfalle, deren Stellung mit Hilfe eines solchen Mikroschalters an eine zugehörige Steuereinrichtung übermittelt wird. Aber auch die Stellung einer Sperrklinke, eines Zentralverriegelungshebels etc. lassen sich mit Hilfe eines solchen Schalters bzw. Mikroschalters abfragen und an die Steuereinrichtung weitergeben.

Beim Stand der Technik nach der DE 43 06 143 A1, von welcher die Erfindung ausgeht, sind Leiterbahnen bzw. elektrische Leitungen in aus Spritzgießkunststoff bestehende Bereiche des Schlossgehäuses im Wege des Spritzgießens eingebettet. Das hat sich bewährt. Zur Kontaktierung der Bauelemente bzw. elektrischen oder elektronischen Bauteile sind außenliegende Anschlussleiter vorgesehen, die beispielhaft in eine Löthülse eingreifen, die von den in das Schlossgehäuse eingelassenen Leiterbahnen geformt wird. Die Kontaktierung erfolgt zumeist durch Verlöten der außenliegenden Anschlussleiter mit der Löthülse.

Zwar wird auch die Möglichkeit angesprochen, die Anschlussleiter demgegenüber in federnde Lippen einzustecken. Das hat sich jedoch in der Praxis nicht durchgesetzt, weil die Anschlussleiter unverändert zugänglich sind und insbesondere in den Kraftfahrzeugtürverschluss eindringendes Spritzwasser zu Kriechströmen führen kann.

Im Rahmen der DE 40 11 980 A1 wird ein Steckschalter beschrieben, der über einen auf einem Steckersockel montierten Schnappschalter verfügt. Der Steckersockel ist zusammen mit dem Schnappschalter stirnseitig in ein Gehäuse eingesetzt, welches zu diesem Zweck muffenartig erweitert und mit einer Schulter versehen ist. Gegen diese Schulter ist eine Dichtscheibe verpresst, wenn der Steckersockel mit Rastvorsprüngen in entsprechende Ausnehmungen an der muffenartigen Erweiterung eingreift.

Durch die DE 36 21 613 A1 ist ein elektrischer Kontaktschalter bekannt geworden, welcher sich insbesondere als Türkontaktschalter für ein Kraftfahrzeug eignet. In einem zugehörigen Gehäuse findet sich ein mit diesem verclipstes, schubladenförmiges Einschubteil, welches Funktionsteile des Kontaktschalters und durch dessen Frontwand über darin eingesetzte Dichtungen hindurchgeführte Anschlüsse aufnimmt.

Schließlich beschäftigt sich die DE 40 02 371 C2 mit einem Gehäuse mit Betätigungsmechanismus für einen Mikroschalter. Durch ein Gehäuse ist dichtend eine mechanische Betätigungseinrichtung geführt, die als im Wesentlichen U-förmig gestaltete Blattfeder ausgebildet ist und im Durchtrittsbereich durch das Gehäuse von einem Dichtelement umgeben wird.

Der Erfindung liegt das technische Problem zugrunde, eine elektrische Bauelementanordnung der eingangs beschriebenen Gestaltung so weiterzubilden, dass bei einfacher Kontaktierung eine zuverlässige Abdichtung insbesondere gegenüber Spritzwasser erreicht wird.

Zur Lösung dieses technischen Problems ist eine gattungsgemäße elektrische Bauelementanordnung dadurch gekennzeichnet, dass das Bauelement mit innenliegenden Kontaktelementen ausgerüstet ist, die im Zuge einer Steckverbindung zwischen Bauelement und Träger die vom Träger vorkragenden Leiterbahnen kontaktieren, wobei das Bauelement mit dem Träger unter Zwischenschaltung einer umlaufenden Dichtung mediendicht verbunden ist. - Bei dem Bauelement handelt es sich üblicherweise um einen (elektrischen oder elektronischen) Schalter bzw. Mikroschalter, wenngleich grundsätzlich natürlich auch andere Bauelemente zum Einsatz kommen können.

In der Regel formen die Dichtung und der Schalter bzw. das Bauelement oder die Dichtung und der Träger eine Baueinheit. Diese Baueinheit lässt sich dadurch realisieren, dass die Dichtung an den Schalter bzw. Träger angespritzt, an diesen angeformt, mit diesem verklebt oder vergleichbar verbunden wird oder ist. In diesem Zusammenhang empfiehlt die Erfindung beispielhaft ein Zwei-Komponenten-Spritzgussverfahren zur Anbringung der umlaufenden Dichtung an das Bauelement und/oder den Träger. Das lässt sich in einem einzügigen Fertigungsprozess durch Anspritzen an die zu dichtenden Flächen erreichen. Der Rückgriff auf zwei Komponenten bei dem beschriebenen Spritzgussverfahren stellt sicher, dass die zugehörige Dichtmasse zunächst die für das Anspritzen erforderliche Flexibilität aufweist und anschließend aushärtet.

Alternativ kann auch in einem separaten Fertigungsschritt eine dichtende Vergussmasse als Dichtung realisiert werden. Dann verfügt der Schalter bzw. das Bauelement oder der Träger zumeist über eine umlaufende Nut, in welche die dichtende Vergussmasse eingebracht wird. So oder so formen die Dichtung und der Schalter bzw. das Bauelement und/oder die Dichtung und der Träger eine Baueinheit. Folglich genügt es zur Realisierung einer mediendichten Verbindung zwischen Bauelement bzw. Schalter und Träger, Bauelement und Träger miteinander zu verbinden, was zumeist im Rahmen einer Steckverbindung geschieht. Hierdurch werden automatisch das Bauelement und auch der Träger bzw. die hieraus vorkragenden Leiterfahnen vor Feuchtigkeit (und Gasen) oder vergleichbaren Medien geschützt und gleichzeitig eine einwandfreie Kontaktierung erreicht.

Bei dem Träger handelt es sich bevorzugt um einen Kunststoffträger, eine Leiterplatte, eine Folie oder dergleichen, die vorzugsweise einen Bestandteil des Schlossgehäuses darstellt. Das heißt, Träger und Schlossgehäuse sind synonym, wenngleich der Träger natürlich auch unabhängig vom Schlossgehäuse ausgeführt sein kann.

Um die bereits angesprochene und vorteilhafte Steckverbindung zwischen dem Bauelement und dem Träger realisieren zu können, schlägt die Erfindung ferner vor, dass der Träger eine an ein Bauelementgehäuse angepasste Aufnahmewanne aufweist. Wenn nun noch Aufnahmebohrungen am Träger und zugehörige Fixierzapfen am Bauelementgehäuse (oder umgekehrt) vorgesehen werden, ist eine einwandfreie Steckverbindung zwischen Bauelement bzw. Bauelementgehäuse und Träger bzw. Aufnahmewanne gewährleistet.

In der Regel ist das Bauelementgehäuse bzw. Schaltergehäuse zweiteilig mit Kerngehäuse und Zwischengehäuse ausgeführt. Diese Ausführungsform empfiehlt sich, wenn beispielsweise eine sogenannte indirekte Kontaktierung erforderlich ist oder das Bauelementgehäuse von seiner Topologie und Ausgestaltung her nicht direkt mit dem Träger vereinigt werden kann. Um nun bei einer solchen Variante die beschriebene Steckverbindung realisieren zu können, sind das Zwischengehäuse und/oder der Träger mit den Aufnahmebohrungen ausgerüstet, während sich die Fixierzapfen am Kerngehäuse befinden. Selbstverständlich ist auch eine umgekehrte Anordnung denkbar, das heißt, dass das Zwischengehäuse und/oder der Träger mit den Fixierzapfen ausgerüstet sind, die in Aufnahmebohrungen am Kerngehäuse eingreifen.

Ferner schlägt die Erfindung vor, das Zwischengehäuse bzw. Bauelementgehäuse mit zusätzlichen Rasthaken auszurüsten, welche in Rastbohrungen im Träger eingreifen. - Um eine mediendichte Verbindung von Zwischengehäuse und Kerngehäuse realisieren zu können, bilden Zwischengehäuse und Kerngehäuse eine Baueinheit, die beispielsweise durch Vergießen, Verkleben etc. hergestellt wird.

Zur direkten Kontaktierung des Bauelementes mit den Leiterfahnen im Träger finden sich an das Bauelement bzw. dessen Bauelementgehäuse angeformte Gabelkontaktelemente, die die Leiterfahnen im Träger ergreifen bzw. umschließen. Daneben ist auch eine indirekte Kontaktierung des Bauelementes bzw. Schalters mit den Leiterfahnen des Trägers möglich. Zu diesem Zweck verfügt das Bauelement über jeweils eine Kontaktfahne bzw. ein Kontaktelement pro Leiterfahne im Träger, wobei auf die Kontaktfahne jeweils ein Kontaktschuh mit Gabelkontaktelement aufgesteckt wird. Das kann entweder in einem separaten Arbeitsschritt erfolgen oder dadurch, dass diese Kontaktschuhe mit jeweiligen Gabelkontaktelementen in das Zwischengehäuse eingelassen sind, so dass die Kontaktierung der Kontaktelemente an dem Bauelement bzw. Schalter mit den Kontaktschuhen automatisch bei der Vereinigung von Bauelementgehäuse und Zwischengehäuse realisiert wird.

Bei der senkrechten Montage des Bauelementes auf dem Träger ist das jeweilige Gabelkontaktelement an den zugehörigen Kontaktschuh in dessen Längsrichtung angeformt. Dagegen schließt das Gabelkontaktelement mit dem zugehörigen Kontaktschuh einen Winkel ein, wenn das Bauelement an dem Träger in abgewinkelter Stellung angebracht wird.

Bei den Leiterbahnen mag es sich um ein Stanzgitter handeln, also eine Leiterbahnanordnung, welche beispielsweise aus einer Metallfolie ausgestanzt ist. Dieses Stanzgitter verfügt über die angeformten Leiterfahnen und ist in ein Isoliermaterial eingebettet, aus welchem üblicherweise der Träger als Ganzes bzw. das Schlossgehäuse gefertigt ist.

Im Ergebnis wird eine elektrische Bauelementanordnung zur Verfügung gestellt, die sich einfach und schnell montieren lässt. Hierfür sorgt die realisierte Steckverbindung zwischen Bauelementgehäuse und Träger bzw. dortiger Aufnahmewanne oder unter Berücksichtigung des zusätzlichen Zwischengehäuses und dem Träger. Dabei stellen die Fixierzapfen sicher, dass die Steckverbindung nur unter Einwirkung einer vorgegebenen Abziehkraft wieder geöffnet werden kann. Gleichzeitig sorgt die umlaufende Dichtung zwischen dem Bauelement und dem Träger dafür, dass Medien, insbesondere Wasser, nicht zwischen Bauelement bzw. Schalter und Träger eindringen kann. Mit elektrischen Kriechströmen verbundene Probleme treten also nicht auf.

Im Folgenden wird die Erfindung anhand einer lediglich ein Ausführungsbeispiel darstellenden Zeichnung näher erläutert; es zeigen:
- **Fig. 1**: eine erfindungsgemäße Bauelementanordnung in Explosionsdarstellung,

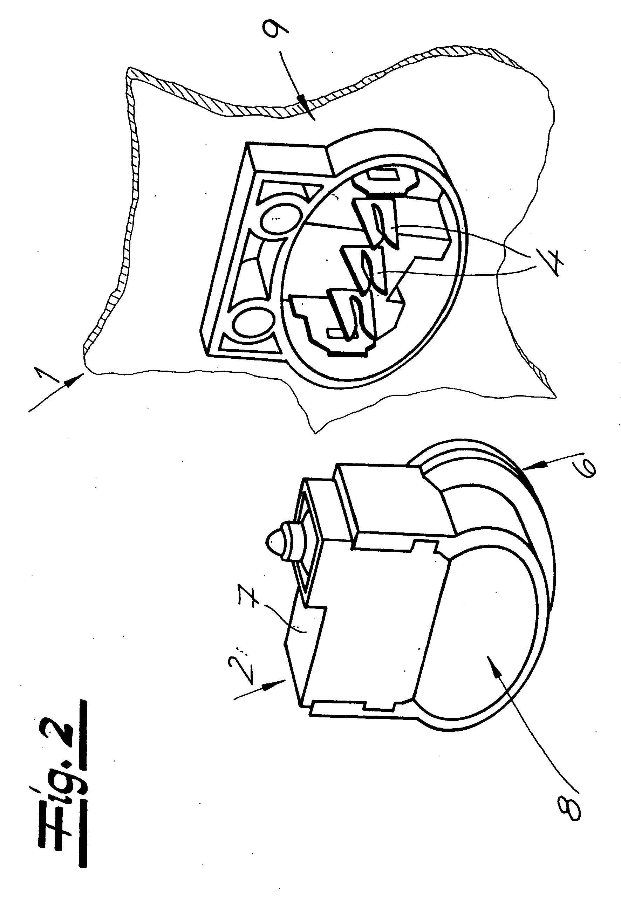

- **Fig. 2**: den Gegenstand nach Fig. 1 im Zuge der Montage,
- **Fig. 3**: eine abgewandelte Ausführungsform bei senkrechter Montage des Bauelementes auf dem zugehörigen Träger und
- **Fig. 4**: eine Variante der Fig. 3 bei abgewinkelter Anbringung des Bauelementes auf dem Träger.

In den Figuren ist eine elektrische Bauelementanordnung dargestellt, die Bestandteil eines Kraftfahrzeugtürverschlusses ist. Dieser Kraftfahrzeugtürverschluss verfügt über ein nicht ausdrücklich gezeichnetes Schlossblech, welches hierin befestigte oder gelagerte Bauteile einer Schließmechanik aufnimmt. Neben dem üblicherweise aus Stahl gefertigten Schlossblech ist ein Schlossgehäuse 1 realisiert, von dem nur ein Teil gezeigt ist. Die grundsätzliche Topologie mag dabei so aussehen und ausgeführt sein, wie dies in der DE 43 06 143 A1 zeichnerisch dargestellt ist.

Das Schlossgehäuse 1 ist mit einem Gehäuseboden und einer Stirnwand ausgerüstet und nimmt elektrische bzw. elektronische Bauelemente 2 auf. Das Schlossgehäuse 1 mit den daran angebrachten Bauelementen 2 wird schließlich mit dem Schlossblech und den dortigen mechanischen Bauteilen zum Kraftfahrzeugtürverschluss im Ganzen vereinigt. - Selbstverständlich kann das Schlossgehäuse 1 neben den elektrischen bzw. elektronischen Bauelementen 2 auch mechanische Bauelemente aufnehmen. Umgekehrt mögen solche Bauelemente 2 natürlich auch dem Schlossblech zugeordnet sein.

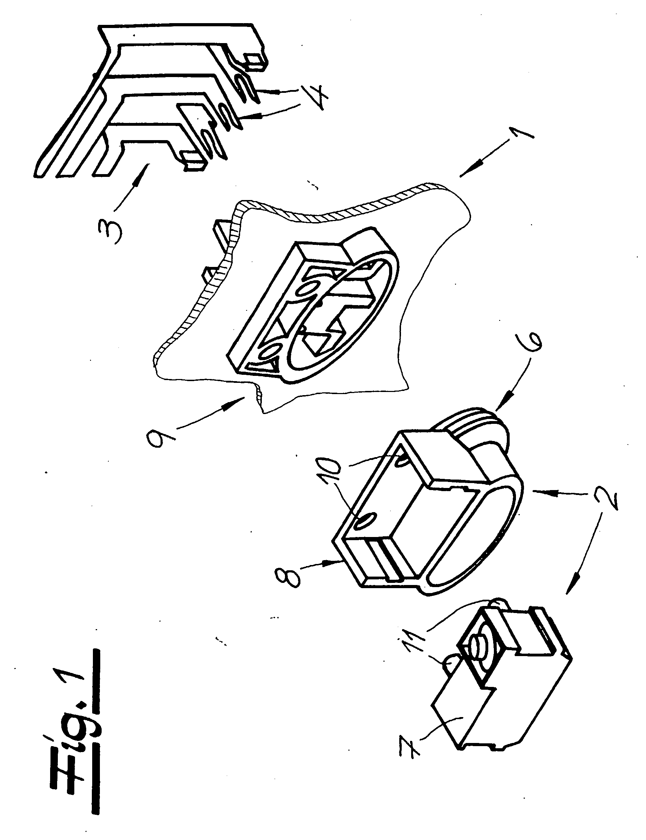

Im Rahmen des Ausführungsbeispiels fungiert das Schlossgehäuse 1 als Träger 1 für wenigstens ein Bauelement 2 und verfügt in diesem Zusammenhang über eingelassene Leiterbahnen 3. Diese Leiterbahnen 3 lassen sich aus einem Metallblech, einer Metallfolie etc. ausstanzen und formen ein Stanzgitter mit angeformten Leiterfahnen 4 (vgl. Fig. 1). Das Stanzgitter bzw. die Leiterbahnen 3 werden in ein Isoliermaterial eingebettet (welches den Träger bzw. das Schlossgehäuse 1 formt). Von dem Träger bzw. Schlossgehäuse 1 kragen die Leiterfahnen 4 vor. Wie man der Fig. 1 entnimmt, münden die Leiterbahnen 3 in die Leiterfahnen 4 bzw. bilden mit diesen ein einstückiges Stanzbauteil.

Erfindungsgemäß ist das Bauelement 2, bei welchem es sich im Rahmen des Ausführungsbeispiels um einen Schalter bzw. Mikroschalter 2 handelt, mit innenliegenden Kontaktelementen 5 ausgerüstet. Diese innenliegenden Kontaktelemente 5 kontaktieren im Zuge einer Steckverbindung zwischen Bauelement 2 und Träger 1 die vom Träger 1 vorkragenden Leiterfahnen 4. Bei diesem Vorgang werden gleichzeitig Bauelement 2 und Träger 4 mediendicht miteinander verbunden. Hierfür sorgt eine zwischen Bauelement 2 und Träger 1 zwischengeschaltete umlaufende Dichtung 6.

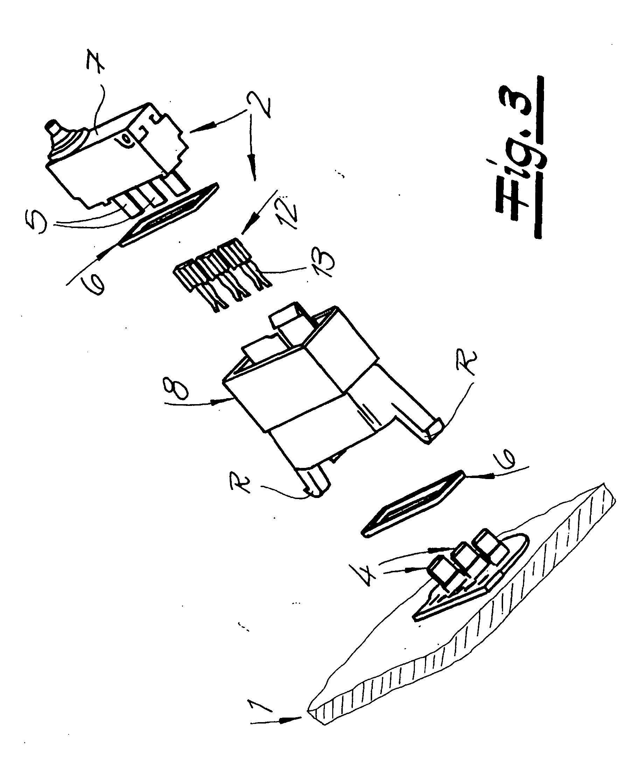

Im Rahmen des Ausführungsbeispiels ist das Bauelement 2 bzw. der Schalter 2 zweiteilig ausgeführt, das heißt sein Bauelementgehäuse bzw. Schaltergehäuse 7, 8 setzt sich aus einem Korngehäuse 7 und einem Zwischengehäuse 8 zusammen. Kerngehäuse 7 und Zwischengehäuse 8 sind als Kunststoffspritzgussteile ausgeführt. Auch der Träger bzw. das Schlossgehäuse 1 ist als Kunststoffspritzgussteil ausgebildet. Das Kerngehäuse 7 wird mit dem Zwischengehäuse 8 vereinigt, was über eine Steck- oder Rastverbindung geschehen kann. Auch an dieser Stelle sorgt eine Dichtung 6 dafür, dass ein mediendichter Verschluss gewährleistet ist (vgl. Fig. 3).

Der Träger 1 verfügt über eine an das Bauelementgehäuse 7, 8 angepasste Aufnahmewanne 9. Das Bauelement- bzw. Schaltergehäuse 7, 8 setzt sich folglich aus dem Kerngehäuse 7 und dem Zwischengehäuse 8 zusammen, was jedoch nicht zwingend ist. Genauso gut könnte das Bauelementgehäuse 7, 8 einteilig ausgeführt sein.

Im Rahmen des Ausführungsbeispiels verfügen das Zwischengehäuse 8 und der Träger 1 über Aufnahmebohrungen 10, die am Kerngehäuse 7 angebrachte Fixierzapfen 11 aufnehmen. Die Fixierzapfen 11 sorgen für eine kraft- und/oder formschlüssige Steckverbindung zwischen Bauelementgehäuse 7, 8 bzw. Kerngehäuse 7 und Zwischengehäuse 8 und Aufnahmewanne 9 bzw. Träger 1 oder Schlossgehäuse 1. Die vorerwähnten Bestandteile 7, 8 und 1 lassen sich demzufolge nur dann (wieder) voneinander trennen, wenn eine bestimmte Kraft aufgewandt wird.

Ausweislich der Fig. 3 mag das Zwischengehäuse 8 noch über Rasthaken R verfügen, die in zugehörige Rastbohrungen im Träger 1 eingreifen. Das Zwischengehäuse 8 und das Kerngehäuse 7 bilden eine Baueinheit, welche durch Verrasten, aber auch durch Vergießen oder Verkleben bzw. vergleichbare Verbindungsarten gebildet werden kann.

Die Kontaktierung geschieht im Einzelnen so, dass zusätzlich zu den innenliegenden Kontaktelementen 5 bezogen auf das Bauelementgehäuse 7, 8 und den vorkragenden Steckfahnen 4 jeweils noch Kontaktschuhe 12 mit zugehörigem Gabelkontaktelementen 13 vorgesehen sind. Im Ausführungsbeispiel finden sich jeweils drei innenliegende Kontaktelemente bzw. Kontaktfahnen 5, auf welche drei Kontaktschuhe 12 mit Gabelkontaktelement 13 aufgesteckt werden, die ihrerseits die drei vorkragenden Leiterfahnen 4 kontaktieren.

Im Rahmen der Darstellung sind die Kontaktschuhe 12 mit Gabelkontaktelement 13 jeweils in das Zwischengehäuse 8 eingesetzt. Wenn nun Zwischengehäuse 8 und Kerngehäuse 7 miteinander vereinigt werden, so werden die Kontaktschuhe 12 direkt auf die Kontaktelemente 5 aufgesteckt. Es kommt also gleichsam zu einer indirekten Kontaktierung.

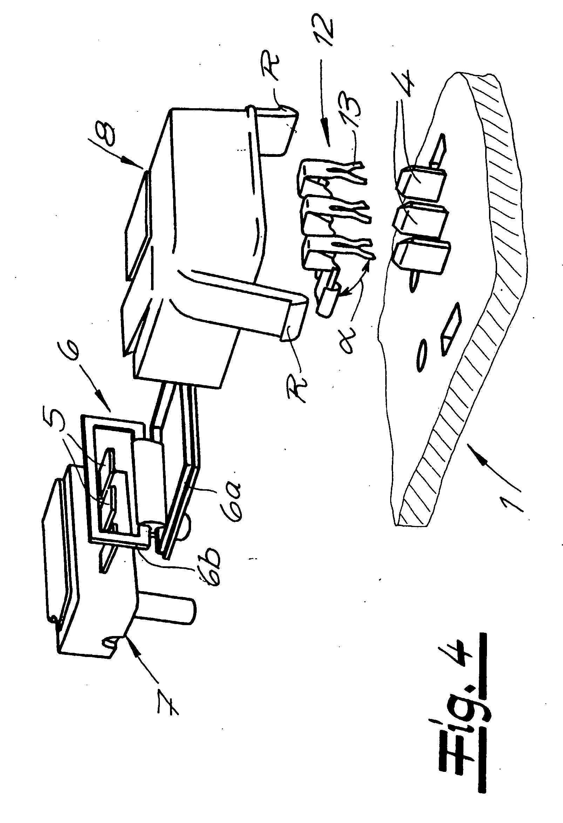

Nicht dargestellt ist die Möglichkeit, die Gabelkontaktelemente 13 unmittelbar an den Schalter 2 zu dessen direkter Kontaktierung mit den Leiterfahnen 4 im Träger 1 anzuformen. So oder so sind die Gabelkontaktelemente 13 an den zugehörigen Kontaktschuh 12 zur senkrechten Montage des Schalters 2 auf den Träger 1 in Längsrichtung angeformt (vgl. Fig. 3) oder sie schließen bei abgewinkelter Montage einen Winkel α mit dem Kontaktschuh 12 ein (vgl. Fig. 4). Im Rahmen dieser Darstellung erkennt man, dass die an sich getrennten beiden Dichtungen 6, einerseits zur Abdichtung des Kerngehäuses 7 gegenüber dem Zwischengehäuse 8, andererseits zur Abdichtung des Zwischengehäuses 8 gegenüber dem Träger 1 auch als einstückige Dichtung 6 mit jeweils abgewinkelten Dichtungsbereichen 6a, 6b ausgeführt sein kann.

Immer gewährleisten die ineinander eingreifenden Kontaktelemente 5 und Leiterfahnen 4 einen einwandfreien elektrischen Übergang. Dabei ist es auch denkbar, dass die Leiterfahnen 4 mit entsprechend angeformten Gabelkontaktelementen 13 ausgerüstet sind, welche die als Zungen ausgebildeten Kontaktelemente 5 am Schalter 2 übergreifen (vgl. Fig. 1). Selbstverständlich können umgekehrt auch die Kontaktelemente 5 am Schalter 2 mit den Gabelkontaktelementen 13 ausgerüstet werden, die dann als Zungen ausgeführte Leiterfahnen 4 übergreifen.

## Patentansprüche

1. Elektrische Bauelementanordnung, insbesondere zur Anbringung auf einem Schlossgehäuse (1) mit eingelassenen Leiterbahnen (3) eines Kraftfahrzeugtürverschlusses, mit einem Träger (1) und einem Bauelement (2), wobei die Leiterbahnen (3) in vom Träger (1) vorkragende Leiterfahnen (4) münden, **dadurch gekennzeichnet, dass** das Bauelement (2) mit innenliegenden Kontaktelementen (5) ausgerüstet ist, die im Zuge einer Steckverbindung zwischen Bauelement (2) und Träger (1) die Leiterfahnen (4) kontaktieren, wobei das Bauelement (2) mit dem Träger (1) unter Zwischenschaltung zumindest einer umlaufenden Dichtung (6, 6a, 6b) mediendicht verbunden ist.

2. Bauelementanordnung nach Anspruch 1, **dadurch gekennzeichnet, dass** das Bauelement (2) als Schalter (2) ausgebildet ist.

3. Bauelementanordnung nach Anspruch 1 oder 2, **dadurch gekennzeichnet, dass** der Träger (1) als Kunststoffträger, Leiterplatte, Folie etc. ausgeführt ist und vorzugsweise einen Bestandteil des Schlossgehäuses (1) formt.

4. Bauelementanordnung nach einem der Ansprüche 1 bis 3, **dadurch gekennzeichnet, dass** der Träger (1) eine an ein Bauelementgehäuse (7, 8) angepasste Aufnahmewanne (9) aufweist.

5. Bauelementanordnung nach Anspruch 4, **dadurch gekennzeichnet, dass** das Bauelementgehäuse (7, 8) zweiteilig mit Kerngehäuse (7) und Zwischengehäuse (8) ausgeführt ist.

6. Bauelementanordnung nach einem der Ansprüche 1 bis 5, **dadurch gekennzeichnet, dass** das Zwischengehäuse (8) und/oder der Träger (1) Aufnahmebohrungen (10) für am Kerngehäuse (7) angebrachte Fixierzapfen (11) aufweisen.

7. Bauelementanordnung nach einem der Ansprüche 1 bis 6, **dadurch gekennzeichnet, dass** das Zwischengehäuse (8) Rasthaken (R) zum Eingriff in Rastausnehmungen im Träger (1) aufweist.

8. Bauelementanordnung nach einem der Ansprüche 1 bis 7, **dadurch gekennzeichnet, dass** das Zwischengehäuse (8) und das Kerngehäuse (7) eine Baueinheit bilden, die beispielsweise durch Verrasten, Vergießen, Verkleben etc. geformt wird.

9. Bauelementanordnung nach einem der Ansprüche 1 bis 8, **dadurch gekennzeichnet, dass** Gabelkontaktelemente (13) an das Bauelement (2) zu dessen direkter Kontaktierung mit den Leiterfahnen (4) im Träger angeformt sind.

10. Bauelementanordnung nach einem der Ansprüche 1 bis 9, **dadurch gekennzeichnet, dass** das Bauelement (2) zur indirekten Kontaktierung mit den Leiterfahnen (4) des Trägers (1) die als Kontaktfahnen (5) ausgebildeten Kontaktelemente (5) aufweist, auf welche jeweils ein Kontaktschuh (12) mit Gabelkontaktelement (13) aufgesteckt ist.

11. Bauelementanordnung nach einem der Ansprüche 1 bis 11 **dadurch gekennzeichnet, dass** das Gabelkontaktelement (13) an den zugehörigen Kontaktschuh (12) zur senkrechten Montage des Bauelementes (2) auf den Träger (1) in Längsrichtung angeformt ist und bei abgewinkelter Montage einen Winkel (α) mit dem Kontaktschuh (12) einschließt.

12. Bauelementanordnung nach einem der Ansprüche 1 bis 11, **dadurch gekennzeichnet, dass** die Leiterbahnen (3) als Stanzgitter mit den angeformten Leiterfahnen (4) ausgeführt sind, welches in ein Isoliermaterial eingebettet ist.

## Claims

1. An electrical component arrangement, in particular for application to a lock housing (1) with let-in conductor paths (3) of a motor vehicle door lock, comprising a support (1) and a component (2), wherein the conductor paths (3) open into conductor lugs (4) projecting from the support (1), **characterised in that** the component (2) is fitted with internal contact elements (5) which contact the conductor lugs (4) in the course of a plug connection between component (2) and support (1), wherein the component (2) is connected in a media-tight manner to the support (1) with at least one interposed circumferential seal (6, 6a, 6b).

2. The component arrangement according to claim 1, **characterised in that** the component (2) is configured as a switch (2).

3. The component arrangement according to claim 1 or 2, **characterised in that** the support (1) is configured as a plastic support, printed circuit board, film etc. and preferably forms a component of the lock housing (1).

4. The component arrangement according to one of claims 1 to 3, **characterised in that** the support (1) has a receiving tray (9) adapted to a component housing (7, 8).

5. The component arrangement according to claim 4, **characterised in that** the component housing (7, 8) is configured in two parts comprising a core housing (7) and an intermediate housing (8).

6. The component arrangement according to one of claims 1 to 5, **characterised in that** the intermediate housing (8) and/or the support (1) have receiving holes (10) for fixing pins (11) attached to the core housing (7).

7. The component arrangement according to one of claims 1 to 6, **characterised in that** the intermediate housing (8) has latching hooks (R) for engagement in latching recesses in the support (1).

8. The component arrangement according to one of claims 1 to 7, **characterised in that** the intermediate housing (8) and the core housing (7) form a structural unit which is formed, for example, by engagement, potting, adhesive bonding etc.

9. The component arrangement according to one of claims 1 to 8, **characterised in that** fork contact elements (13) are formed on the component (2) for direct contact of said component with the conductor lugs (4) in the support.

10. The component arrangement according to one of claims 1 to 9, **characterised in that** for indirect contact with the conductor lugs (4) of the support (1) the component (2) has contact elements (5) configured as contact lugs (5) on which respectively one contact shoe (12) with fork contact element (13) is placed.

11. The component arrangement according to one of claims 1 to 11, **characterised in that** the fork contact element (13) is formed on the relevant contact shoe (12) for perpendicular mounting of the component (2) on the support (1) in the longitudinal direction and when mounted at an angle, encloses an angle (α) with the contact shoe (12).

12. The component arrangement according to one of claims 1 to 11, **characterised in that** the conductor paths (3) are configured as a stamped grid with conductor lugs (4) formed thereon, which is embedded in an insulating material.

## Revendications

1. Montage électrique d'un composant, notamment pour le montage sur un boîtier de serrure (1) avec des conducteurs imprimés (3) encastrés d'une fermeture de portière de véhicule automobile, avec un support (1) et un composant (2), les conducteurs imprimés (3) débouchant sur des pattes de conducteurs (4) faisant saillie sur le support (1), **caractérisé en ce que** le composant (2) est équipé d'éléments de contact intérieurs (5) permettant de mettre en contact les pattes de conducteur (4) au cours d'une connexion enfichable entre le composant (2) et le support (1), le composant (2) étant relié de façon étanche au support (1) avec intercalation d'au moins un joint périphérique (6, 6a, 6b).

2. Montage d'un élément de construction selon la revendication 1, **caractérisé en ce que** le composant (2) est conçu comme un interrupteur.

3. Montage de composant selon la revendication 1 ou 2, **caractérisé en ce que** le support (1) est conçu comme un support en plastique, un circuit imprimé, un film, etc. et constitue de préférence un composant du boîtier de serrure (1).

4. Montage de composant selon l'une des revendications 1 à 3, **caractérisé en ce que** le support (1) comporte une cuve d'admission (9) adaptée à un boîtier de composant (7, 8).

5. Montage de composant selon la revendication 4, **caractérisé en ce que** le boîtier de composant (7, 8) est conçu en deux parties, avec un boîtier central (7) et un boîtier intermédiaire (8).

6. Montage de composant selon l'une des revendications 1 à 5, **caractérisé en ce que** le boîtier intermédiaire (8) et/ou le support (1) comportent des perçages d'admission (10) pour des pivots de fixation (11) fixés sur le boîtier central (7).

7. Montage de composant selon l'une des revendications 1 à 6, **caractérisé en ce que** le boîtier intermédiaire (8) comporte des crochets d'encliquetage (R) pour l'engagement dans des évidements d'encliquetage situés dans le support (1).

8. Montage de composant selon l'une des revendications 1 à 7, **caractérisé en ce que** le boîtier intermédiaire (8) et le boîtier central (7) constituent une unité de construction formée par exemple par encliquetage, scellage, collage, etc.

9. Montage de composant selon l'une des revendications 1 à 8, **caractérisé en ce que** des éléments de contact à fourche (13) sont formés sur le composant (2), pour la mise en contact directe de celui-ci avec les pattes de conducteur (4) dans le support.

10. Montage de composant selon l'une des revendications 1 à 9, **caractérisé en ce que** le composant (2) comporte les éléments de contact (5) formés comme des pattes de contact (5), destinés à la mise en contact indirecte avec les pattes de conducteur (4) du support (1), et sur chacun desquels est monté un patin de contact (12) avec élément de contact à fourche (13).

11. Montage de composant selon l'une des revendications 1 à 11, **caractérisé en ce que** l'élément de contact à fourche (13) est formé dans le sens longitudinal sur le patin de contact (12) correspondant, pour le montage vertical du composant (2) sur le support (1), et forme un angle (α) avec le patin de contact (12) lorsque le montage est terminé.

12. Montage de composant selon l'une des revendications 1 à 11, **caractérisé en ce que** les conducteurs imprimés (3) sont conçus comme un patron de découpage, avec les pattes de conducteurs (4) rapportées, enrobé dans un matériau isolant.
